# EUROPEAN PATENT SPECIFICATION

(11) **EP 2 057 629 B1**
(45) Date of publication and mention of the grant of the patent: **04.08.2010**
(21) Application number: 07806585.1
(22) Date of filing: 28.08.2007
(51) Int. Cl.: G11B 7/26, G11B 9/10, G11B 5/84, G03F 7/20, H01J 37/317

(54) **DRAWING METHOD AND DRAWING DEVICE**
ZEICHENVERFAHREN UND ZEICHENVORRICHTUNG
PROCÉDÉ DE MARQUAGE ET DISPOSITIF DE MARQUAGE

(30) Priority: 31.08.2006 JP 2006235419
(43) Date of publication of application: 13.05.2009
(73) Proprietor: Ricoh Company, Ltd., Tokyo 143-8555 (JP); CRESTEC CORPORATION, Kokubunji-shi Tokyo 185-0003 (JP)
(72) Inventor: MIYAZAKI, Takeshi, Tokyo 185-0003 (JP); MURAYAMA, Noboru, Kanagawa 229-0011 (JP)
(74) Representative: Mounteney, Simon James
(86) International application number: PCT/JP2007/067112
(87) International publication number: WO 2008/026759

(56) References cited:
- EP-A- 0 248 588
- EP-A- 1 267 340
- JP-A- 2002 288 890
- JP-A- 2003 248 983
- US-A- 5 721 432
- US-A1- 2006 102 853
- US-B1- 6 835 937

## Description

### TECHNICAL FIELD

This invention relates to a drawing method, a drawing device, and an information recording medium. More particularly, this invention relates to a drawing method and device in which an electron beam is radiated to a surface of an object to draw a pattern on the object surface. And this invention relates to an information recording medium on which a pattern is formed on a recording surface by using the drawing method and device.

### BACKGROUND ART

In the field of digitization of information in recent years, there is an increasing demand for a large amount of storage capacity of optical disc. Research and development of next generation optical discs on which information is recorded and reproduced by a radiated ultraviolet light beam having a wavelength on the order of 400nm, for example, are performed briskly instead of research and development of the existing optical discs, such as CD (compact disc) or DVD (digital versatile disc).

Also in the field of magnetic disc devices, such as a hard disc drive, miniaturization of the magnetic disc device and improvement of the recording density are an important issue. In recent years, patterned media on which a pattern for realizing advanced tracking of the recording head is formed beforehand on the surface of the media have come to appear.

In the manufacturing processes of patterned media and base substrates (stampers) of next generation optical discs, a pattern of very small pits is formed in corresponding recording layers of those media. Electron-beam drawing devices capable of drawing a pattern of extremely thin lines on a recording medium have been widely used.

For example, Japanese Laid-Open Patent Application No. 2002-288890 and Japanese Laid-Open Patent Application No. 2003-248983 disclose an electron-beam drawing device of this kind. The electron beam drawing device of this kind is provided to draw a pattern of extremely thin lines on a substrate, such as a silicon wafer to which a resist material is coated. In drawing such a pattern on the substrate, an electron beam radiated to the substrate is deflected while the substrate is rotated. And blanking of the electron beam and irradiation of the substrate by the electron beam is repeatedly performed so that a spiral or concentric-circle pattern is drawn on the surface of the substrate.

However, the drawing method and device according to the related art are inadequate for speedily drawing a pattern with sufficient accuracy on a surface of a recording medium.

US 2006/0102853 discloses a device and a method for imaging and positioning a multi particle beam on a substrate is disclosed. A particle beam source is provided with a condenser optic that produces a particle beam that illuminates the surface of an aperture plate. A multiplicity of individual beams are produced from the particle beam by means of the aperture plate.

### DISCLOSURE OF THE INVENTION

According to one aspect of the invention, there is provided an improved drawing method and device in which the above-described problems are eliminated.

According to one aspect of the invention there is provided a drawing method which speedily draws a pattern with sufficient accuracy on a surface of an object.

According to one aspect of the invention there is provided a drawing device which speedily draws a pattern with sufficient accuracy on a surface of an object.

In an embodiment of the invention which solves or reduces one or more of the above-mentioned problems, there is provided a drawing method according to claim 1. be configured so that the deflecting step is provided to deflect the electron beam periodically in one of the first direction and the second direction, so that a beam spot of the deflected electron beam is positioned alternately to one of a first scan line and a second scan line among the scan lines.

The above-mentioned drawing method may be configured so that the drawing step is provided to rotate the object to cause relative movement of the object to the electron beam.

Also disclosed is an information recording medium on which a periodic pattern is formed on a recording surface by using the above-mentioned drawing method.

In an embodiment of the invention which solves or reduces one or more of the above-mentioned problems, there is provided a drawing device according to claim 5.

The above-mentioned drawing method may be configured so that the deflection unit deflects the electron beam periodically in one of the first direction and the second direction, so that a beam spot of the deflected electron beam is positioned alternately to one of a first scan line and a second scan line among the scan lines.

The above-mentioned drawing method may be configured so that the moving unit rotates the object to cause relative movement of the object to the electron beam.

Also disclosed is an information recording medium on which a periodic pattern is formed on a recording surface by using a drawing device, the drawing device radiating an electron beam to a surface of the information recording medium to draw a pattern along scan lines on the surface of the information recording medium, the drawing device comprising: an electron source emitting an electron beam; an objective lens converging the electron beam emitted by the electron source on the information recording medium surface; a pulse oscillator outputting a pulse signal which defines the pattern to be drawn on the information recording medium surface; a deflection unit deflecting, in response to the pulse signal from the pulse oscillator, the electron beam at a speed that does not cause a pattern to be formed on the information recording medium surface, in one of a first direction intersecting the scan lines and a second direction opposite to the first direction, on the information recording medium surface without performing blanking, so that a beam spot of the deflected electron beam is positioned to one of the scan lines on the information recording medium surface; and a moving unit moving the information recording medium relative to the electron beam.

According to embodiments of the drawing method and device of the invention, it is possible to speedily draw a pattern with sufficient accuracy on a surface of an object.

### BRIEF DESCRIPTION OF THE DRAWINGS

Other objects, features and advantages of the present invention will be apparent from the following detailed description when reading in conjunction with the accompanying drawings.
FIG. 1 is a diagram showing the composition of a vacuum drawing device in an embodiment of the invention.
FIG. 2 is an enlarged diagram showing the composition of an irradiation device in the vacuum drawing device of FIG. 1.
FIG. 3A is a plan view of a substrate W.
FIG. 3B is an enlarged diagram showing a pattern formed in a small area PA in the area MA of the substrate W of FIG. 3A.
FIG. 4 is a diagram showing the waveform of a pulse voltage PV applied to a second deflecting electrode.
FIG. 5 is a diagram for explaining a method of drawing marks M on a surface of a substrate W.
FIG. 6A is a diagram for explaining a modification of marks M formed on a track.
FIG. 6B is a diagram for explaining a modification of marks M formed on a track.
FIG. 7 is a diagram for explaining a modification of the drawing method of the invention.

### BEST MODE FOR CARRYING OUT THE INVENTION

A description will be given of embodiments of the invention with reference to the accompanying drawings.

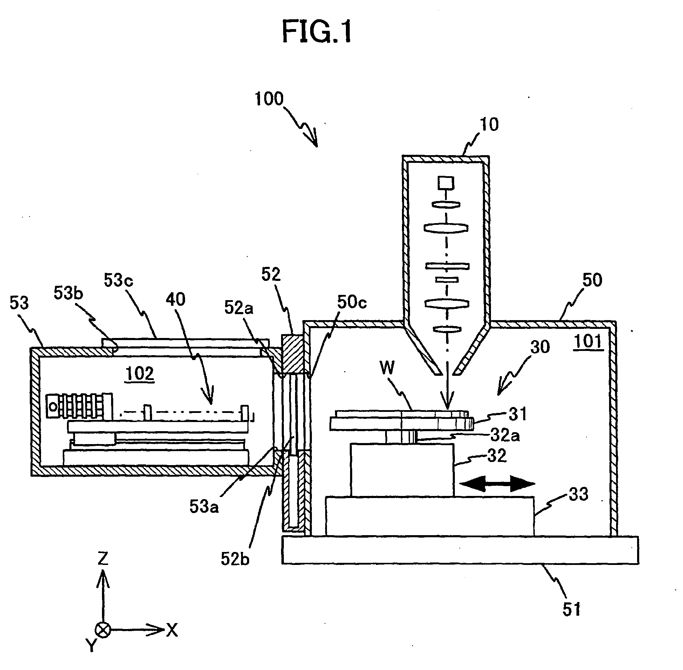

FIG. 1 shows the composition of a vacuum drawing device 100 in an embodiment of the invention. This vacuum drawing device 100 irradiates an electron beam to a circular disc-like substrate W in which a drawing surface is formed by coating of a resist material, under the environment where a degree of vacuum is set to 10⁻⁴ Pa, for example, so that a pattern of extremely thin lines is drawn on the drawing surface of the substrate W.

As shown in FIG. 1, the vacuum drawing device 100 generally includes a rotating table unit 30, an irradiation device 10, a transport unit 40, a first vacuum chamber 50, a gate valve 52, a second vacuum chamber 53, and a main control unit (not shown).

The substrate W is laid on the rotating table unit 30. The irradiation device 10 radiates an electron beam to the surface of the substrate W. The transport unit 40 performs loading of the substrate W into and unloading of the substrate W from the rotating table unit 30.

In the first vacuum chamber 50, the rotating table unit 30 is accommodated. The second vacuum chamber 53 is connected to the first vacuum chamber 50 through the gate valve 52. The main control unit controls the component parts of the vacuum drawing device 100.

The first vacuum chamber 50 is a hollow component in the shape of a rectangular parallelepiped and this first vacuum chamber 50 has the bottom end (-Z side) open. The longitudinal direction of the first vacuum chamber 50 is parallel to the X direction, and the lower end portion is secured to the top of a surface plate 51 without clearance.

The first vacuum chamber 50 has an opening in the upper surface into which the bottom end of the irradiation device 10 is inserted, and has a rectangular opening 50c in the -X side surface. The longitudinal direction of the opening 50c is parallel to the Y direction.

The rotating table unit 30 is arranged on the surface plate 51 within the first vacuum chamber 50. The rotating table unit 30 includes a rotating table 31, a spindle motor 32, and a slide unit 33. The substrate W is laid on the rotating table 31. The spindle motor 32 supports horizontally the rotating table 31 and rotates the rotating table 31 around a shaft 32a at a predetermined rotational speed. The slide unit 33 supports the spindle motor 32 and moves the spindle motor 32 in the X direction by a predetermined stroke.

The second vacuum chamber 53 is a hollow component in the shape of a rectangular parallelepiped and the longitudinal direction of this second vacuum chamber 53 is parallel to the X direction. The second vacuum chamber 53 is connected to the -X side surface of the first vacuum chamber 50 through the gate valve 52. The second vacuum chamber 53 has a rectangular opening 53a in the +X side surface and the shape of the opening 53a is identical to that of the opening 50c.

The second vacuum chamber 53 has an opening 53b in the upper surface and the size of the opening 53b is larger than that of the substrate W. A lid 53 is arranged on the upper surface of the second vacuum chamber 53 so that the lid 53 is slidable in the X direction. Sliding the lid 53c enables opening and closing of the opening 53b to the exterior space.

The gate valve 52 includes a frame portion and a gate 52b. In the frame portion, an opening 52a which penetrates in the X direction is formed. The gate 52b is slidable in the Z direction, and sliding the gate 52b enables opening and closing of the opening 52a.

Both the +X side end and the -X side end of the frame portion of the gate valve 52 are secured without clearance to the surrounding side walls of the opening 50c of the first vacuum chamber 50 and the opening 53a of the second vacuum chamber 53 respectively. Accordingly, when the gate 52b of the gate valve 52 is slid in the +Z direction to close the opening 52a, the internal space (called vacuum process chamber 101) formed by the first vacuum chamber 50 and the surface plate 51 and the interior space (called load lock chamber 102) of the second vacuum chamber 53 are maintained at a predetermined degree of vacuum.

On the other hand, when the gate 52b is slid in the -Z direction to open the opening 52a, the vacuum process chamber 101 and the load lock chamber 102 are opened to freely communicate with the exterior space.

Hereinafter, operation to open and close the opening 52a by sliding the gate 52b will be referred to as opening and closing of the gate valve 52.

The transport unit 40 is arranged on the top surface of the bottom wall of the second vacuum chamber 53. This transport unit 40 includes an arm which holds the substrate W, and a drive mechanism which drives movement of the arm to transport the substrate W in the X direction.

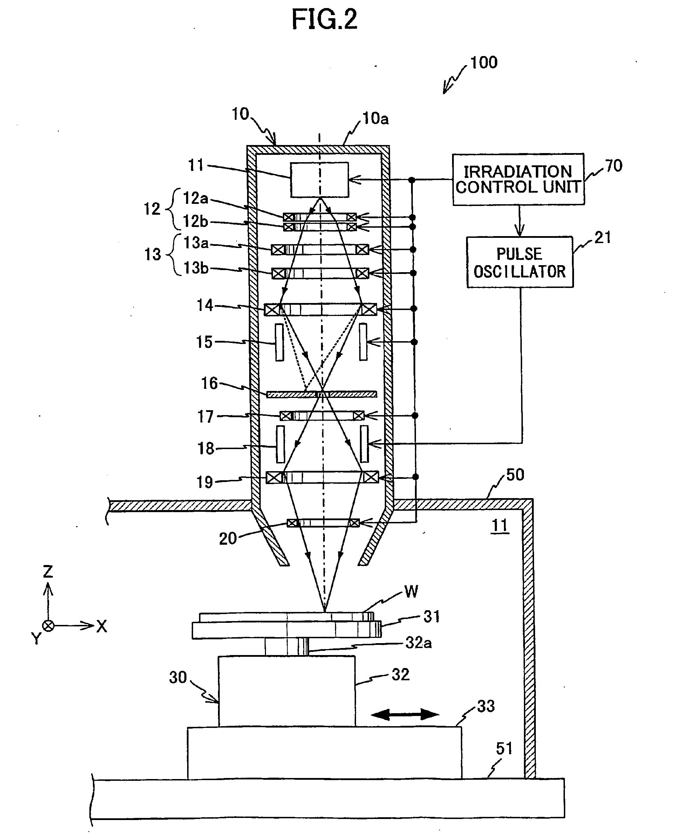

FIG. 2 is an enlarged diagram showing the composition of the irradiation device 10 in the vacuum drawing device 100 of FIG. 1.

As shown in FIG. 2, the irradiation device 10 includes a casing 10a and the longitudinal direction of the casing 10a is parallel to the Z direction. In the casing 10a of the irradiation device 10, there are arranged sequentially from the top to the bottom an electron source 11, an electrostatic lens 12, an axial alignment coil 13, a converging lens 14, a first deflecting electrode 15, an aperture 16, an astigmatism compensation coil 17, a second deflecting electrode 18, an objective lens 19, a dynamic focus correction lens 20, an irradiation control unit 70, and a pulse oscillator 21.

The casing 10a is a cylindrical casing having the lower end open, and this casing 10a is fitted into the opening formed in the top surface of the first vacuum chamber 50 without clearance.

The -Z side end portion of the casing 10a is arranged inside the first vacuum chamber 50 and it has a tapered configuration in which the diameter of the end portion decreases in the -Z direction.

The electron source 11 is arranged in the uppermost position inside the casing 10a. The electron source 11 is a thermal field emission type electron source which emits an electron derived from the cathode by application of heat and electric field. Typically, the electron source 11 emits an electron beam having a diameter on the order of 20-50nm downward (in the -Z direction).

The electrostatic lens 12 has a pair of cylindrical lenses 12a and 12b which are arranged under the electron source 11 so that the cylindrical lenses 12a and 12b are adjoined in the Z direction. Mutually different voltages are applied to the cylindrical lenses 12a and 12b. When the electron beam emitted from electron source 11 passes the cylindrical lenses 12a and 12b, the electrostatic force is given to deform the electron beam in the converging direction.

The converging lens 14 is arranged under the electrostatic lens 12 via the axial alignment coil 13. The converging lens 14 serves to converge the electron beam passing through the electrostatic lens 12.

The axial alignment coil 13 is arranged between the electrostatic lens 12 and the converging lens 14. The axial alignment coil 13 has a pair of toroidal coils 13a and 13b which are arranged so that the coils 13a and 13b are adjoined in the Z direction. The axial alignment coil 13 serves to correct an axial deviation of the electron beam passing through the space between the electrostatic lens 12 and the converging lens 14.

The first deflecting electrode 15 is arranged under the converging lens 14. The first deflecting electrode 15 has a pair of electrodes which are arranged on the +X side and the -X side of the optical axis of the converging lens 14 so that the electrodes confront each other. And the first deflecting electrode 15 deflects the electron beam, passing through the converging lens 14, selectively in one of the +X direction and the -X direction in response to the voltage applied by the irradiation control unit 70.

The aperture 16 is a plate-like component in which an opening is formed in the center of the plate-like component, and an electron beam passes through the aperture opening. The aperture 16 is arranged under the first deflecting electrode 15 so that the aperture opening is located on the optical axis of the converging lens 14.

The astigmatism compensation coil 17 is an annular coil which is arranged under the aperture 16, and the astigmatism compensation coil 17 serves to correct the astigmatism of the electron beam passing through the aperture 16.

The second deflecting electrode 18 is arranged under the astigmatism compensation coil 17. The second deflecting electrode 18 has a pair of electrodes which are arranged on the +X side and the -X side of the optical axis of the converging lens 14 so that the electrodes confront each other. The second deflecting electrode 18 deflects the electron beam, passing through the aperture 16, selectively in one of the +X direction and the -X direction in response to the voltage applied by the irradiation control unit 70 through the pulse oscillator 21.

The objective lens 19 is arranged under the second deflecting electrode 18, and this objective lens 19 converges the electron beam, passing through the second deflecting electrode 18, onto the surface of the substrate W which is laid on the rotating table 31.

The dynamic focus correction lens 20 serves to adjust finely the diameter of a beam spot of the electron beam converged on the surface of the substrate W by the objective lens 19.

The pulse oscillator 21 applies a pulse voltage, which is represented by, for example, a square wave having a frequency on the order of several megahertz, to the second deflecting electrode 18 in accordance with the instructions from the irradiation control unit 70.

The irradiation control unit 70 drives the electron source 11 and controls the component parts 12-21 of the irradiation device 10 mentioned above, respectively.

In the above-described irradiation device 10, the electron beam emitted from the electron source 11 is converging when passing through the electrostatic lens 12 and the converging lens 14, and a point of convergence of the electron beam is formed in the vicinity of the opening of the aperture 16 (the point of convergence will be called a crossover point).

Subsequently, the electron beam passing through the crossover point is diverging and passes through the aperture 16 so that the beam diameter is adjusted.

Subsequently, the astigmatism of the electron beam is corrected by the astigmatism compensation coil 17, and the electron beam is converged onto the surface of the substrate W, laid on the rotating table 31, by the objective lens 19.

The position in which the electron beam is converged on the surface of the substrate W surface and a beam spot is formed will be referred to as a converging position.

In parallel to the above-mentioned operation, the voltage applied to the first deflecting electrode 15 is controlled, and the electron beam is deflected in the -X direction and covered by the aperture 16 as indicated by the dotted lines in FIG. 2, so that blanking of the electron beam to the substrate W is carried out.

Moreover, the voltage applied to the second deflecting electrode 18 is controlled and the electron beam is deflected in one of the -X direction and the +X direction so that the position of a beam spot of the electron beam is moved in the radial direction of the substrate W.

Next, the method of forming a pattern on the substrate W by using the above-described vacuum drawing device 100 will be explained.

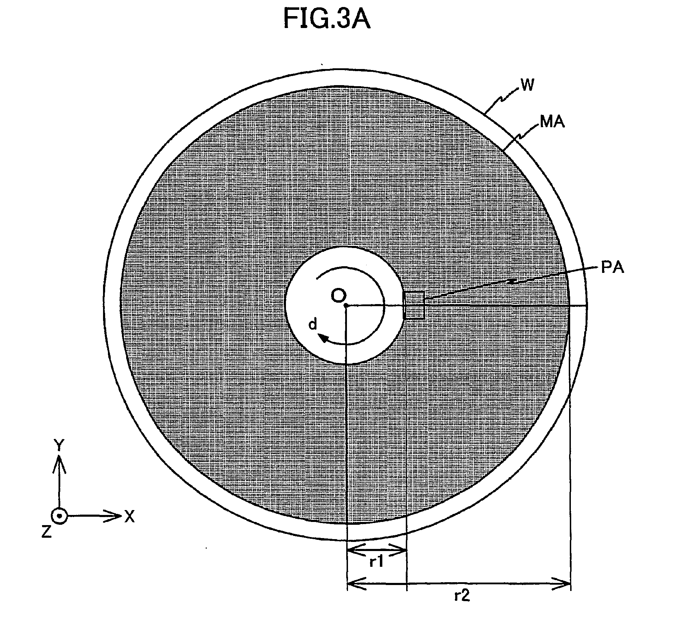

For the sake of convenience of explanation, it is supposed that a pattern is drawn on the area MA of the substrate W surrounded by the circle having a radius r1 and the circle having a radius r2 around the center O of the substrate W, the area MA of the substrate W being indicated by the shaded part in FIG. 3A.

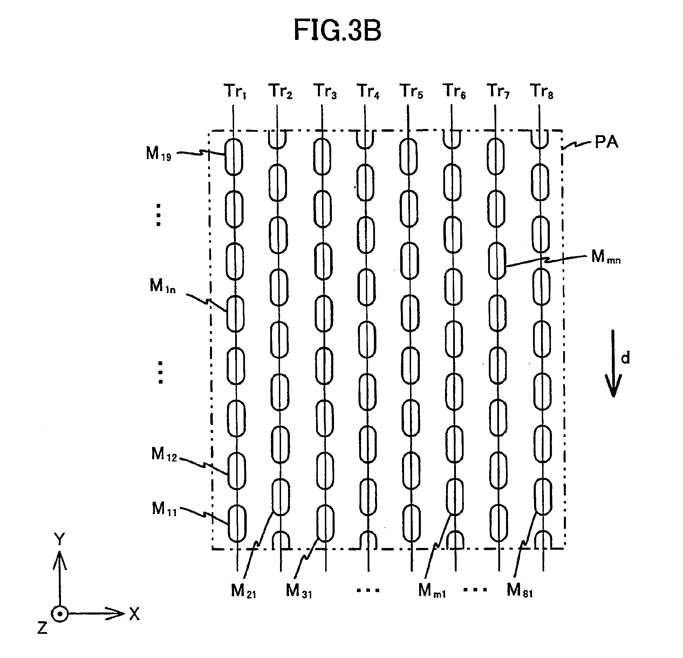

FIG. 3B is an enlarged diagram showing a small area PA in the area MA of the substrate W of FIG. 3A. As shown in FIG. 3B, a plurality of marks M in the shape of a concentric circle around the center O of the substrate W are formed in the area MA along a plurality of tracks Tr which are defined at intervals of about 0.4 micrometer.

In this embodiment, the tracks Tr in the area PA shown in FIG. 3B (and in the entire area MA) are defined as being Tr1, Tr2, Tr3, ..., Trm (m= 1, 2, ...) in the left-to-right direction from the -X side to the +X side of the area PA. And the marks M drawn along the track Trm are defined as being Mmn (n= 1, 2, ...) in the down-to-up direction from the -Y side to the +Y side of the area PA.

Suppose that the length of each mark M along the track and the distance between the marks M along the track are approximately 0.25 micrometers. Also suppose that, in the irradiation device 10, the electron source 11 is driven by the irradiation control unit 70, the driving voltage is applied to the first deflecting electrode 15, and the irradiation device 10 is in the state in which blanking of the electron beam is performed with the aperture 16.

When the substrate W is transported to the upper portion of the load lock chamber 102 by a transport system (not shown), the main control unit controls the driving of the lid 53c to slide in the -X direction to open the opening 53b. And when the substrate W is received by and passed to the transport unit 40, the driving of the lid 53c is controlled to slide in the +X direction to close the opening 53b so that the internal space of the load lock chamber 102 is held in airtight condition.

Subsequently, using a vacuum pump (not shown), the main control unit performs vacuum suction of the internal space of the load lock chamber 102 held in airtight condition until a predetermined degree of vacuum (for example, 10⁻⁴ Pa) equivalent to the degree of vacuum inside the vacuum process chamber 101 is reached. Thereafter, the main control unit opens the gate valve 52.

Subsequently, the main control unit drives the transport unit 40 to transport the substrate W from the load lock chamber 102 to the vacuum process chamber 101 via the gate valve 52 and place the substrate W on the rotating table 31. Thereafter, the transport unit 40 is evacuated to the load lock chamber 102, and the gate valve 52 is closed.

Subsequently, marks Mmn are continuously formed along one of track Tr1 and track Tr2 in the area PA by using the electron beam from the irradiation device 10, so that a pattern is drawn along track Tr1 and track Tr2.

Next, a detailed description will be given of the method of drawing a pattern.

As described above, when the substrate W is laid on the rotating table 31, the main control unit controls the driving of the slide unit 33 to position the substrate W such that the converging position of a beam spot of the electron beam is on track Tr1.

Subsequently, the main control unit outputs an operation start instruction to the irradiation control unit 70 and drives the spindle motor 32 of the rotating table unit 30 to rotate the rotating table 31.

Accordingly, the substrate W laid on the rotating table 31 is rotated in the direction indicated by the arrow d in FIG. 3A, at a circumferential speed of 1m/s (which is equivalent to a moving speed of a beam spot on each track of the recording medium).

Meanwhile, upon reception of the operation start instruction from the main control unit, the irradiation control unit 70 applies, to the second deflecting electrode 18 through the pulse oscillator 21, the voltage (pulse voltage) PV which is represented by a pulse waveform having a frequency of about 1 MHz. At the same time, the irradiation control unit 70 stops the application of the voltage to the first deflecting electrode 15.

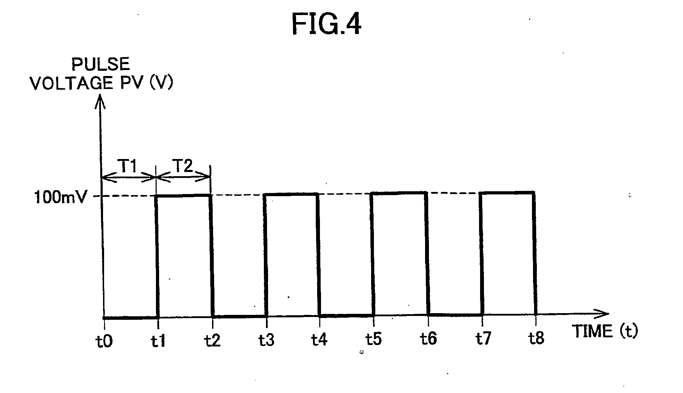

FIG. 4 shows the waveform of the pulse voltage PV applied to the second deflecting electrode 18.

As shown in FIG. 4, the pulse voltage PV is represented by a voltage waveform, consisting of off-time T1 and on-time T2, and the voltage in on-time is set to 100mV.

When the pulse voltage PV shown in FIG. 4 is applied to the second deflecting electrode 18, the electron beam emitted from the electron source 11 is periodically deflected by the second deflecting electrode 18, such that the electron beam is deflected in the +X direction in synchronization with a rise of the pulse voltage PV and it is deflected in the -X direction in synchronization with a fall of the pulse voltage PV.

Specifically, a beam spot, which is on track Tr1 at time instant t0, is moved in the +X direction at time instant t1 (the pulse voltage PV is set to ON after the passing of off-time Tl) and positioned to track Tr2. And the beam spot is moved in the -X direction at time instant t2 (the pulse voltage PV is set to OFF after the passing of off-time T2 from time instant t1) and is positioned to track Tr1.

Subsequently, this operation is repeated for every time instant (t3, t5, t7, ...) that the pulse voltage PV is set to ON, and for every time instant (t4, t6, t8, ...) that the pulse voltage PV is set to OFF.

Since movement of a beam spot is performed by the second deflecting electrode 18 to which the pulse voltage PV having the rectangular shape is applied, the time needed for the beam spot to move between the tracks is a very short time. For this reason, any pattern is not drawn in the area PA during the movement of the beam spot between the tracks.

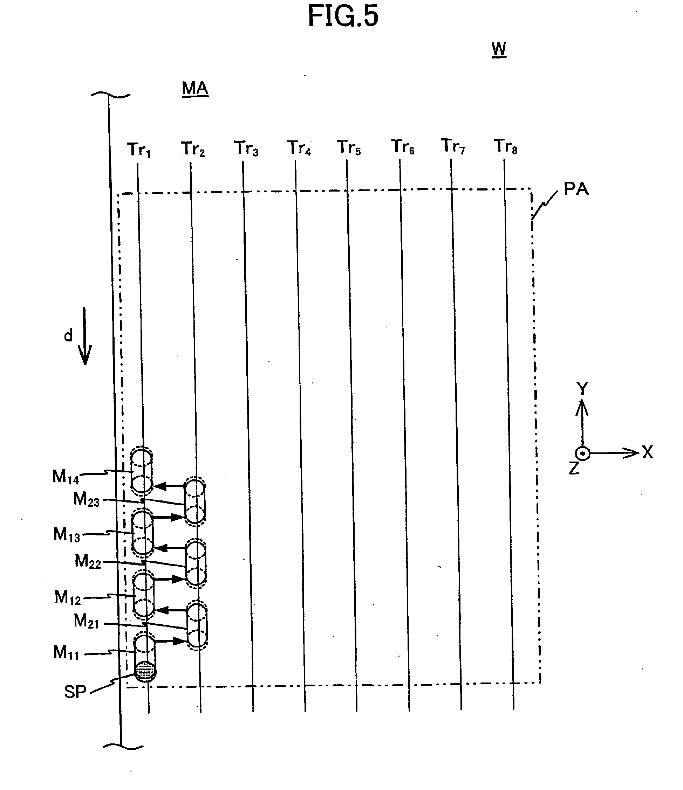

FIG. 5 is a diagram for explaining a method of drawing marks on a surface of a substrate W.

As shown in FIG. 5, a beam spot SP of an electron beam which is positioned to track Tr1 at time instant t0 is moved in the +Y direction in the area PA during the passing of off-time T1, so that a mark M11 is formed along track Tr1 on the substrate W. And the beam spot SP, which is positioned to track Tr2 when the electron beam is deflected at time instant t2, is moved in the +Y direction in the area PA during the passing of on-time T2, so that a mark M21 is formed along track Tr2 on the substrate W.

Subsequently, the above-mentioned operation is repeated, so that marks M12, M22, M13, M23, ..., M1m, and M2m are sequentially formed along each of track Tr1 and track Tr2.

Accordingly, as shown in FIG. 3B, the repeated pattern in which the marks M are arranged at equal intervals is drawn along tracks Tr1 and Tr2 respectively.

After the drawing of the pattern of the tracks Tr1 and Tr2 is completed, the main control unit drives the slide unit 33 to position the beam spot to track Tr3. Similarly, the deflection of an electron beam is performed periodically, and the repeated pattern in which the marks M are arranged at equal intervals is drawn along tracks Tr3 and Tr4 respectively.

When the formation of marks M for all the tracks included in the area MA of the substrate W is completed by repeating the above-mentioned operation, the main control unit stops the rotation of the rotating table 31, and, at the same time, outputs an electron-beam blanking instruction to the irradiation control unit 70.

Subsequently, the substrate W is unloaded from the vacuum drawing device 100 in an unloading procedure which is the reversal of the above-mentioned loading procedure.

In the vacuum drawing device 100 of this embodiment, the electron beam which is converged on the area MA of the substrate W (which is rotated at a speed that is equivalent to the circumferential speed of about 1 m/S and does not allow formation of a pattern on the substrate W by the electron beam) is periodically deflected in one of the +X direction and the -X direction, without performing blanking of the electron beam, when the pulse voltage PV is applied to the second deflecting electrode 18.

Thereby, the beam spot SP of the electron beam is positioned periodically to one of the tracks Trm defined in the area MA, and the electron beam contributes to the drawing of marks Mmn along one of the tracks Trm invariably. Accordingly, it is possible to draw a pattern on the surface of the substrate speedily.

For example, if the formation of the pattern of FIG. 3B along tracks Trm is performed by repeating the drawing and the blanking, it is necessary that after the drawing is done during on-time T1, the blanking of the electron beam is carried out during off-time T2. For this reason, the ratio of utilization of the electron beam is represented by 1/2(T1/(T1+T2)). Therefore, the vacuum drawing device 100 which does not need blanking during the drawing of the pattern is allowed to complete the drawing of marks M on the substrate W in an approximately half time.

Generally, in order to carry out blanking of an electron beam, it is necessary to deflect the electron beam greatly. However, in the vacuum drawing device 100 of this embodiment is adapted to deflect the electron beam slightly to move the beam spot between tracks, and the position accuracy of the beam spot on track can be improved.

Specifically, it is necessary to produce a potential difference of about 10V being applied to the first deflecting electrode 15 at the time of blanking. However, at the time of movement of a beam spot between tracks, it is adequate for the vacuum drawing device 100 of this embodiment to produce a potential difference of about 10mV being applied to the second deflecting electrode 18.

For this reason, the influences due to the time constant of the electrodes can be reduced, and it is possible to raise the response and position accuracy characteristics remarkably.

As for the vacuum drawing device 100 of the above-mentioned embodiment, the case in which the marks M having the same shape are formed on the tracks Tr1 and Tr2 has been described. Alternatively, the vacuum drawing device 100 of the above-mentioned embodiment may be modified so that marks M having different shape are formed on the tracks Tr1 and Tr2 by changing the waveform of the pulse voltage PV to have different off-time T1 and/or different on-time T2.

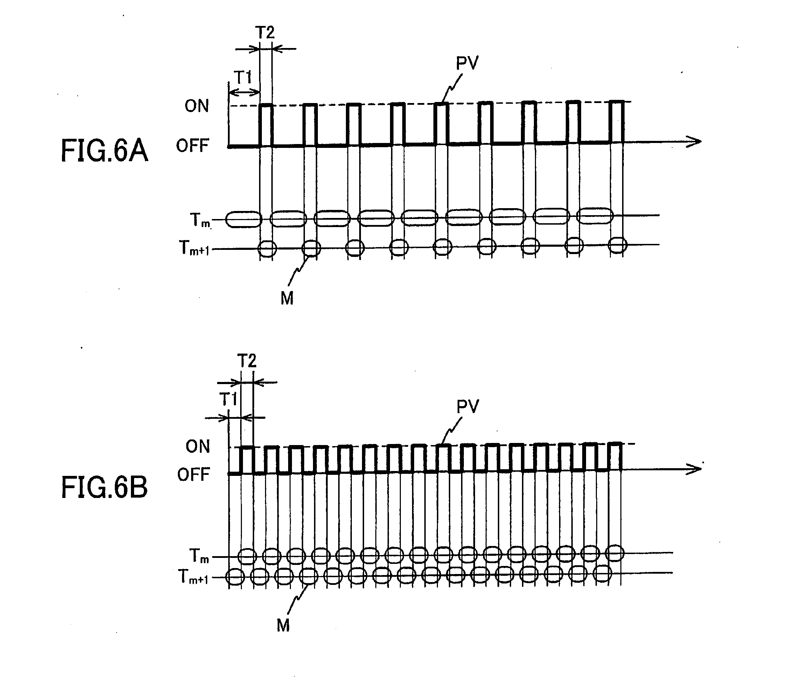

For example, as shown in FIG. 6A, the vacuum drawing device 100 of the above-mentioned embodiment may be modified by shortening the on-time T2 of the pulse voltage PV to form the mark M having the shape, which is the same as that of the above-mentioned mark M, on the track Trm, and form a mark M having the shape, whose length is shorter than the length of the above-mentioned mark M, on the track Trm+1.

Moreover, the width of deflection of an electron beam varies depending on the amplitude of the pulse voltage PV. For example, if the amplitude of the pulse voltage PV is increased, the amount of movement of a beam spot is enlarged, and the amplitude of the pulse voltage PV is decreased, the amount of movement of a beam spot can be reduced.

In a case in which a recording disc used for a patterned medium is the substrate W mentioned above, the vacuum drawing device 100 of the above-mentioned embodiment may be modified by setting the on-time T1, the off-time T2, and the amplitude of the pulse voltage PV to smaller values respectively, as shown in FIG. 6B. In this case, a pattern of small-dot marks M arranged in proximity in the shape of a honeycomb can be formed on the substrate W by irradiating the substrate surface by the electron beam.

Also in this case, blanking of the electron beam is not performed, and it is possible to shorten the time needed to draw the pattern on the substrate W. Moreover, it is possible to raise the accuracy of drawing of a pattern on the substrate W.

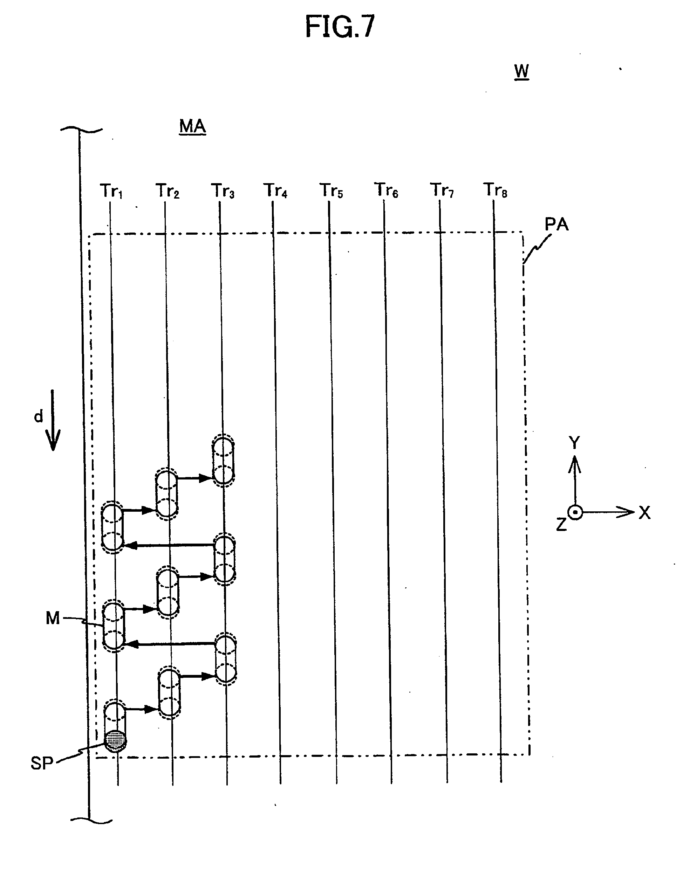

As for the vacuum drawing device 100 of the above-mentioned embodiment, an example of the arrangement of the marks M shown in FIG. 3B has been described. Alternatively, the above-mentioned embodiment may be modified by deflecting the electron beam in a different manner as shown in FIG. 7. In such alternative embodiment, the beam spot SP is positioned to one of the tracks Tr1, Tr2, Tr3 in the area PA, and the marks M are formed selectively on one of the tracks Tr1, Tr2, Tr3.

In short, the vacuum drawing device 100 of the invention is constituted so that the electron beam is deflected, without performing blanking of the electron beam, so that the marks are formed on one of the tracks in a cyclic manner.

Also in this case, the electron beam contributes to the drawing of marks along one of the tracks Trm invariably, and it is possible to raise the accuracy of drawing of a pattern.

In the above-mentioned embodiment, positioning of the beam spot SP can be performed to one of the tracks Tr1, Tr2, Tr3. Alternatively, positioning of the beam spot SP may be performed to one of other tracks, such as Tr1, Tr3, Tr6, and it is also possible to position the beam spot SP to one of four or more tracks alternately.

As for the above-mentioned embodiment, the case in which the marks M are formed on each of the adjacent tracks has been explained. Alternatively, the above-mentioned embodiment may be modified so that the electron beam is deflected in one of the +X direction and the -X direction centered on a certain track and the marks M are formed continuously on one of the both sides of the track.

As for the above-mentioned embodiment, the case in which the tracks Trm in the shape of a concentric circle are formed has been described. Alternatively, the above-mentioned embodiment may be modified so that while the substrate W is rotated by the rotating table 31, the substrate W is slid in the X direction by the slide unit 33 at a predetermined speed, so that marks M are formed along a spiral track.

As for the above-mentioned embodiment, the case in which the substrate W laid on the rotating table 31 is rotated and a pattern consisting of marks M is drawn along the tracks has been described. However, this invention is not limited to this embodiment. For example, the above-mentioned embodiment may be modified so that the substrate W is laid on an XY stage which is movable in both the X direction and the Y direction, the substrate W is moved in the Y direction relative to the electron beam, and the electron beam is periodically deflected by the first deflecting electrode 15, so that a pattern consisting of marks M is formed along a scan line parallel to the Y direction.

In the vacuum drawing device 100 of the above-mentioned embodiment, the blanking of the electron beam is performed by the first deflecting electrode 15 of the irradiation device 10, and the deflecting of the electron beam is performed by the second deflecting electrode 18 so that the movement of a beam spot between the tracks is performed. Alternatively, the above-mentioned embodiment may be modified so that the pulse voltage is applied to the first deflecting electrode 15 to deflect the electron beam periodically and perform the movement of a beam spot between the tracks.

Moreover, if the positioning accuracy falls within the tolerance, the first deflecting electrode 15 and the second deflecting electrode 18 may be formed into a common deflecting electrode. This enables miniaturization and low-cost production of the vacuum drawing device. The tracks Tr defined on the substrate W in this embodiment should be interpreted as being inclusive of not only tracks which are actually formed on the substrate W, but also design tracks which are used as the reference lines when forming marks M and defined by the marks drawn on the substrate W.

## Claims

1. A drawing method in which an electron beam is radiated to a surface of an object to draw a pattern along scan lines on the surface of the object, the drawing method comprising steps of :
drawing a pattern along the scan lines on the surface of the object by the electron beam through relative movement of the object relative to the electron beam;
deflecting the electron beam at a speed that does not cause a pattern to be formed on the object surface; and
repeating alternately the drawing step and the deflecting step, **characterised in that**:
the electron beam is deflected in one of a first direction intersecting the scan lines and a second direction opposite to the first direction, without performing blanking, so that a beam spot of the deflected electron beam is positioned to one of the scan lines on the object surface;

2. The drawing method according to claim 1, wherein the deflecting step is provided to deflect the electron beam periodically in one of the first direction and the second direction, so that a beam spot of the deflected electron beam is positioned alternately to one of a first scan line and a second scan line among the scan lines

3. The drawing method according to claim 1, wherein the drawing step is provided to rotate the object to cause relative movement of the object to the electron beam.

4. A method of producing an information recording medium wherein a periodic pattern is formed on a recording surface by using the drawing method according to claim 1.

5. A drawing device (100) which is arranged to radiate an electron beam to a surface of an object to draw a pattern along scan lines on the surface of the object, the drawing device (100) comprising:
an electron source (11) arranged to emit an electron beam;
an objective lens (19) arranged to converge the electron beam emitted by the electron source (11) on the object surface;
a pulse oscillator (21) arranged to output a pulse signal which defines the pattern to be drawn on the object surface;
a deflection unit (15, 18) arranged to deflect, in response to the pulse signal from the pulse oscillator (21), the electron beam at a speed that does not cause a pattern to be formed on the object surface; and
a moving unit (30) arranged to cause relative movement of the object to the electron beam, **characterised in that**,
the deflection unit (15,18) is arranged to deflect the electron beam in one of a first direction intersecting the scan lines and a second direction opposite to the first direction, without performing blanking of the electron beam, so that a beam spot of the deflected electron beam is positioned to one of the scan lines on the object surface.

6. The drawing device (100) according to claim 5, wherein the deflection unit (15, 18) is arranged to deflect the electron beam periodically in one of the first direction and the second direction, so that a beam spot of the deflected electron beam is positioned alternately to one of a first scan line and a second scan line among the scan lines.

7. The drawing device (100) according to claim 5, wherein the moving unit (30) is arranged to rotate the object to cause relative movement of the object to the electron beam.

## Patentansprüche

1. Zeichenverfahren, in dem ein Elektronenstrahl auf eine Oberfläche eines Objekts abgestrahlt wird, um ein Muster entlang den Abtastlinien auf der Oberfläche des Objekts zu zeichnen, wobei das Zeichenverfahren folgende Schritte umfasst:
Zeichnen eines Musters entlang den Abtastlinien auf der Oberfläche des Objekts durch den Elektronenstrahl durch Relativbewegung des Objekts relativ zum Elektronenstrahl;
Ablenken des Elektronenstrahls mit einer Geschwindigkeit, die nicht bewirkt, dass ein Muster auf der Objektoberfläche geformt wird; und
abwechselndes Wiederholen des Zeichenschritts und des Ablenkungsschritts, **dadurch gekennzeichnet, dass:**
der Elektronenstrahl in eine von folgenden Richtungen abgelenkt wird: eine erste Richtung, die die Abtastlinien schneidet, und eine zweite Richtung, die der ersten Richtung entgegengesetzt ist, ohne Austastung auszuführen, sodass ein Strahlfleck des abgelenkten Elektronenstrahls auf eine der Abtastlinien auf der Objektoberfläche positioniert wird.

2. Zeichenverfahren nach Anspruch 1, worin der Ablenkungsschritt bereitgestellt wird, um den Elektronenstrahl periodisch in eine der ersten Richtung und der zweiten Richtung abzulenken, sodass ein Strahlfleck des abgelenkten Elektronenstrahls abwechselnd auf eine erste Abtastlinie und eine zweite Abtastlinie unter den Abtastlinien positioniert wird.

3. Zeichenverfahren nach Anspruch 1, worin der Zeichenschritt zum Rotieren des Objekts bereitgestellt wird, um Relativbewegung des Objekts zum Elektronenstrahl zu bewirken.

4. Verfahren zum Erzeugen eines Informationsaufzeichnungsmediums, worin ein periodisches Muster auf einer Aufzeichnungsfläche durch Verwenden des Zeichenverfahrens gemäß Anspruch 1 geformt wird.

5. Zeicheneinrichtung (100), die dazu angeordnet ist, einen Elektronenstrahl auf eine Oberfläche eines Objekts abzustrahlen, um ein Muster entlang Abtastlinien auf der Oberfläche des Objekts zu zeichnen, wobei die Zeicheneinrichtung (100) umfasst:
eine Elektronenquelle (11), die zum Emittieren eines Elektronenstrahls angeordnet ist;
eine Objektivlinse (19), die dazu angeordnet ist, den von der Elektronenquelle (11) emittierten Elektronenstrahl auf die Objektoberfläche zu konvergieren;
einen Pulsoszillator (21), der dazu angeordnet ist, ein Pulssignal auszugeben, das das auf die Objektoberfläche zu zeichnende Muster definiert;
eine Ablenkungseinheit (15; 18), die dazu angeordnet ist, als Antwort auf das Pulssignal vom Pulsoszillator (21) den Elektronenstrahl mit einer Geschwindigkeit abzulenken, die nicht bewirkt, dass auf der Objektoberfläche ein Muster geformt wird; und
eine Bewegungseinheit (30), die dazu angeordnet ist, Relativbewegung des Objekts zum Elektronenstrahl zu bewirken, **dadurch gekennzeichnet, dass:**
die Ablenkungseinheit (15, 18) dazu angeordnet ist, den Elektronenstrahl in eine von folgenden Richtungen abzulenken: eine erste Richtung, die die Abtastlinien schneidet, und eine zweite Richtung, die der ersten Richtung entgegengesetzt ist, ohne Austastung des Elektronenstrahls auszuführen, sodass ein Strahlfleck des abgelenkten Elektronenstrahls auf eine der Abtastlinien auf der Objektoberfläche positioniert wird.

6. Zeicheneinrichtung (100) nach Anspruch 5, worin die Ablenkungseinheit (15, 18) dazu angeordnet ist, den Elektronenstrahl periodisch in eine der ersten Richtung und der zweiten Richtung abzulenken, sodass ein Strahlfleck des abgelenkten Elektronenstrahls abwechselnd auf eine erste Abtastlinie und eine zweite Abtastlinie unter den Abtastlinien positioniert wird.

7. Zeicheneinrichtung (100) nach Anspruch 5, worin die Bewegungseinheit (30) dazu angeordnet ist, das Objekt zu rotieren, um Relativbewegung des Objekts zum Elektronenstrahl zu bewirken.

## Revendications

1. Procédé de dessin dans lequel un faisceau électronique est rayonné vers une surface d'un objet pour dessiner un motif le long de lignes de balayage sur la surface de l'objet, le procédé de dessin comprenant les étapes consistant à :
dessiner un motif le long des lignes de balayage sur la surface de l'objet par le faisceau électronique par l'intermédiaire d'un mouvement relatif de l'objet par rapport au faisceau électronique ;
défléchir le faisceau électronique à une vitesse qui n'entraîne pas la formation d'un motif sur la surface de l'objet ; et
répéter alternativement l'étape de dessin et l'étape de déflexion, **caractérisé en ce que :**
le faisceau électronique est défléchi dans l'une d'une première direction croisant les lignes de balayage et d'une deuxième direction opposée à la première direction, sans effectuer de suppression de faisceau, de sorte qu'un point de faisceau du faisceau électronique défléchi soit positionna sur l'une des lignes de balayage sur la surface de l'objet.

2. Procédé de dessin selon la revendication 1, dans lequel l'étape de déflexion est prévue pour défléchir le faisceau électronique périodiquement dans l'une de la première direction et de la deuxième direction, de sorte qu'un point de faisceau du faisceau électronique défléchi soit positionné alternativement sur l'une d'une première ligne de balayage et d'une deuxième ligne de balayage parmi les lignes de balayage.

3. Procédé de dessin selon la revendication 1, dans lequel l'étape de dessin est prévue pour faire tourner l'objet pour provoquer un mouvement relatif de l'objet par rapport au faisceau électronique.

4. Procédé de production d'un support d'enregistrement d'informations, dans lequel un motif périodique est formé sur une surface d'enregistrement en utilisant le procédé de dessin selon la revendication 1.

5. Dispositif de dessin (100) qui est agencé pour rayonner un faisceau électronique vers une surface d'un objet pour dessiner un motif le long de lignes de balayage sur la surface de l'objet, le dispositif de dessin (100) comprenant :
une source d'électrons (11) agencée pour émettre un faisceau électronique ;
une lentille de focalisation (19) agencée pour faire converger le faisceau électronique émis par la source d'électrons (11) sur la surface de l'objet ;
un oscillateur à impulsions (21) agencé pour délivrer un signal impulsionnel qui définit le motif dessiner sur la surface de l'objet ;
une unité de déflexion (15, 18) agencée pour défléchir, en réponse au signal impulsionnel provenant de l'oscillateur à impulsions (21), le faisceau électronique à une vitesse qui n'entraîne pas la formation d'un motif sur la surface de l'objet ; et
une unité mobile (30) agencée pour provoquer un mouvement relatif de l'objet par rapport au faisceau électronique, **caractérisé en ce que :**
l'unité de déflexion (15, 18) est agencée pour défléchir le faisceau électronique dans l'une d'une première direction croisant les lignes de balayage et d'une deuxième direction opposée à la première direction, sans effectuer de suppression du faisceau électronique, de sorte qu'un point de faisceau du faisceau électronique défléchi soit positionné sur l'une des lignes de balayage sur la surface de l'objet.

6. Dispositif de dessin (100) selon la revendication 5, dans lequel l'unité de déflexion (15, 18) est agencée pour défléchir le faisceau électronique périodiquement dans l'une de la première direction et de la deuxième direction, de sorte qu'un point de faisceau du faisceau électronique défléchi soit positionné alternativement sur l'une d'une première ligne de balayage et d'une deuxième ligne de balayage parmi les lignes de balayage.

7. Dispositif de dessin (100) selon la revendication 5, dans lequel l'unité mobile (30) est agencée pour faire tourner l'objet pour provoquer un mouvement relatif de l'objet par rapport au faisceau électronique.
